# EUROPEAN PATENT APPLICATION

(11) **EP 4 715 848 A1**
(43) Date of publication of application: **25.03.2026**
(21) Application number: 25202490.6
(22) Date of filing: 16.09.2025
(51) Int. Cl.: H01F 27/28

(54) **COUPLING COEFFICIENT OF A TRANSFORMER**

(30) Priority: 24.09.2024 FR 2410189
(71) Applicant: STMicroelectronics International N.V., 1228 Plan-les-Ouates, Geneva (CH)
(72) Inventor: AZEVEDO DE SOUZA E VECCHIA, Vinicius, 38240 MEYLAN (FR)
(74) Representative: Cabinet Beaumont

(57) **Abstract**

The present disclosure relates to a transformer (3) comprising a first coil (300) and a second coil (302) inductively coupled the one with the other. The first coil comprises at least one first winding (3000) arranged in a first plan for generating a first magnetic field perpendicular to the first plan, and at least one second winding (3002) arranged in the first plan for generating a second magnetic field perpendicular to the first plan and opposite to the first field. In the first plan, a ratio between a surface delimited by the first winding (3000) and a surface delimited by the second winding (3002) is determined by a target value of a coupling coefficient between the two coils (300; 500).

## Description

### Technical field

The present disclosure relates generally to electronic circuits, for example to integrated electronic circuits. The present disclosure relates more particularly to a transformer of an integrated circuit.

### Background art

Transformers are widely used in integrated electronic circuits. A transformer comprises one first coil ("bobine" en fran 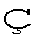 ais) and one second coil, inductively coupled with each other. One of the first and second coils correspond to the primary of the transformer, and the other one of the first and second coils correspond to the secondary of the transformer. The coupling between the primary and secondary of the transformer is given by a value of a coupling coefficient K between the two coils.

A transformer is, for example, used in radio-frequency electronic circuits to perform an impedance matching between a source of a radio-frequency signal and a load receiving the radio-frequency signal provided by the source. Such a transformer is, for example, used as a balancing unit or balun between the source and the load. As an example, a radio-frequency signal has a frequency superior or equal to 1 GHz, preferably to 5 GHz. For example, a radio-frequency signal has a frequency comprised in the range from 1 GHz to 300 GHz. However, such a transformer used as a balancing unit could be used with signal having frequency outside the range indicated above as an example, for example with signal that is not a radio-frequency signal.

When a transformer is placed between the source and load impedances, the power transferred from the source to the load is maximal at a single first resonant frequency if the coupling coefficient K between the primary and the secondary of the transformer is equal to 1, for example in absolute value. At the first frequency, the source and the load are said to be matched ("adapté" en fran 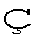 ais). In order to ensure the matching of the load and the source for more than the single first frequency, it is known to decrease the value of K. By doing so, a second higher resonant frequency appears. It is further known that, by carefully choosing the inductance values of the primary and the secondary and the K value, the value of the first and second resonant frequencies can be adapted, or selected, in order to obtain a wideband matching between the source and the load.

The ability to construct transformers with a coefficient K having a value equal to a target value is thus of particular interest, for example, to get a wideband matching between a source and a load, although this may be interesting in other applications and circuits comprising a transformer.

The known transformers of integrated circuits in which the coupling coefficient K between a primary and a secondary coils of the transformer can be set to a target value however suffers from drawbacks, for example, regarding a variation on an area occupied by the transformer when the target value varies, or, for example, regarding a variation in the impedance values of the primary and secondary coils when the target value varies. The area of a transformer is, for example, the total area of a surface in which the transformer is included, for example in a plan parallel to the windings of the coils of the transformer.

### Summary of Invention

There is a need to address all or some of the drawbacks of known transformers, for example, of known transformers implemented in integrated circuits, for example, in the metal layers of an interconnexion structure of the integrated circuits.

One embodiment addresses all or some of the drawbacks of known transformers, for example, of known transformers implemented in integrated circuits, for example, in the metal layers of an interconnexion structure of the integrated circuits.

For example, one embodiment provides a transformer in which a change in the target value of the coupling coefficient K between the primary and the secondary of the transformer is implemented without modifying the area occupied by the transformer. Said in other word, one embodiment provides, for example, a transformer which can have a first implementation corresponding to a first value of K, and a second implementation corresponding to a second value of K, with an area identical for these two implementations.

For example, one embodiment provides a transformer in which a change in the target value of the coupling coefficient K between the primary and the secondary of the transformer is implemented without modifying the inductance values of the first and second coils of the transformer. Said in other word, one embodiment provides, for example, a transformer which can have a first implementation corresponding to a first value of K, and a second implementation corresponding to a second value of K, with an inductance value of the primary having the same value in these two implementations and an inductance value of the secondary having the same value in these two implementations.

One embodiment provides a transformer comprising a first coil and a second coil inductively coupled the one with the other. The first coil comprises:
- at least one first winding arranged in a first plan and configured to generate a first magnetic field in a first direction perpendicular to the first plan; and
- at least one second winding arranged in the first plan and configured to generate a second magnetic field in a second direction perpendicular to the first plan and opposite to the first direction. The first coil is 8-shaped and asymmetrical. When the first and second coils are arranged in different plans, the first and second coils have a same area, and a footprint of the first coil projected on a projection plan parallel to said different plans is identical to a footprint of the second coil projected on the projection plan. When the first and second coils are both arranged in the first plan, one of the first and second coils is arranged in a surface laterally delimited by the other of the first and second coils, the first and second coils having sensibly a same footprint.

According to one embodiment, the at least one first winding comprises a plurality of concentric first windings and the at least one second winding comprises a plurality of concentric second windings, a number of second windings being, for example, equal to a number of first windings.

According to one embodiment, the at least one first winding comprises only one first winding and the at least one second winding comprise only one second winding.

According to one embodiment, the second coil comprises at least one third winding arranged in a second plan and configured to generate a third magnetic field in a third direction parallel to the first and second direction, the second plan being parallel to the first plan.

According to one embodiment, the second coil is configured to generate only the third magnetic field.

According to one embodiment:
- the second plan is coplanar with the first plan;
- a third surface laterally delimited by the at least one third winding comprises, in the second plan, a first part included in a first surface laterally delimited by the at least one first winding and a second part included in a second surface laterally delimited by the at least one second winding .

According to one embodiment:
- the second plan is different from the first plan;
- a third surface laterally delimited by the at least one third winding comprises, in the second plan, a first part facing, in a direction parallel to the first and second directions, a first surface laterally delimited by the at least one first winding in the first plan, and a second part facing, in the direction parallel to the first and second directions, a second surface laterally delimited by the at least one second winding in the first plan.

According to one embodiment, the second coil further comprises at least one fourth winding arranged in the second plan and configured to generate a fourth magnetic field in a fourth direction parallel to the first and second directions and opposite to the third direction, the second plan being different from the first plan.

According to one embodiment, the at least one third winding comprises a plurality of third windings and the at least one fourth winding comprises a plurality of fourth windings, a number of third windings being equal to a number of fourth windings.

According to one embodiment, the first and second windings are arranged in a first metal layer and the first and second windings are connected to each other by at least one metallic portion arranged in at least one metal layer different from the first metal layer, the length of the at least one metallic portion being determined by a target value of a parasitic capacitance between the first and second windings.

According to one embodiment, the transformer further comprises a third coil inductively coupled with each of the first and second coils.

A further embodiment provides an integrated radio-frequency circuit comprising a balancing unit connected between a source impedance and a load impedance in a circuit, the balancing unit comprising a transformer as defined above.

### Brief description of drawings

The foregoing features and advantages, as well as others, will be described in detail in the following description of specific embodiments given by way of illustration and not limitation with reference to the accompanying drawings, in which:
Figure 1 illustrates, by a schematic top view, an example of a transformer having a value of the coupling coefficient between the primary and the secondary of the transformer equal to a target value;
Figure 2 illustrates, by a schematic top view, another example of a transformer having a value of the coupling coefficient between the primary and the secondary of the transformer equal to a target value;
Figure 3 illustrates, by a schematic tri-dimensional view, an example of an embodiment of a transformer having a value of the coupling coefficient between the primary and the secondary of the transformer equal to a target value;
Figure 4 illustrates, by a schematic tri-dimensional view, an example of an embodiment of a transformer having a value of the coupling coefficient between the primary and the secondary of the transformer equal to a target value;
Figure 5 illustrates, by a schematic tri-dimensional view, an example of an embodiment of a transformer having a value of the coupling coefficient between the primary and the secondary of the transformer equal to a target value;
Figure 6 illustrates, by a schematic tri-dimensional view, an example of an embodiment of a transformer having a value of the coupling coefficient between the primary and the secondary of the transformer equal to a target value;
Figure 7 illustrates, by a schematic tri-dimensional view, an example of an embodiment of a transformer having a value of the coupling coefficient between the primary and the secondary of the transformer equal to a target value;
Figure 8 illustrates, by a schematic tri-dimensional view, an example of an embodiment of a transformer having a value of the coupling coefficient between the primary and the secondary of the transformer equal to a target value;
Figure 9 illustrates, by a schematic tri-dimensional view, an example of an embodiment of a transformer having a value of the coupling coefficient between the primary and the secondary of the transformer equal to a target value;
Figure 10 illustrates, by a schematic tri-dimensional view, an example of an embodiment of a transformer having a value of the coupling coefficient between the primary and the secondary of the transformer equal to a target value; and
Figure 11 illustrates, by a schematic tri-dimensional view, an example of an embodiment of a transformer having a value of the coupling coefficient between the primary and the secondary of the transformer equal to a target value.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 % or 10°, and preferably within 5 % or 5°.

Preferably, unless specified otherwise, in the following disclosure, a coil ("bobine" en fran 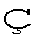 ais) comprises at least one winding ("enroulement" en fran 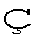 ais) or loop ("boucle" en fran 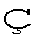 ais) connecting the two extremities, or terminals, of the coil together. For example, said in other words, a coil comprises only one winding or loop connecting the two extremities, or terminals, of the coil, or comprises a plurality of windings or loops successively connected between the two extremities, or terminals, of the coil.

Preferably, unless specified otherwise, in the following disclosure, the expression "a winding (or a loop) is arranged in a plan" signify that:
- the winding (or loop) comprises a first part corresponding to more than the a third, preferably more than a half, of the length of the winding (or loop),
- the first part of the winding (or loop) is comprised between a first plan coplanar with a first surface of the first part of the winding (or loop) and a second plan coplanar with a second surface of the first part of the winding (or loop), and
- the two plans are further parallel the one with the other and to the plan the winding (or loop) is arranged in.

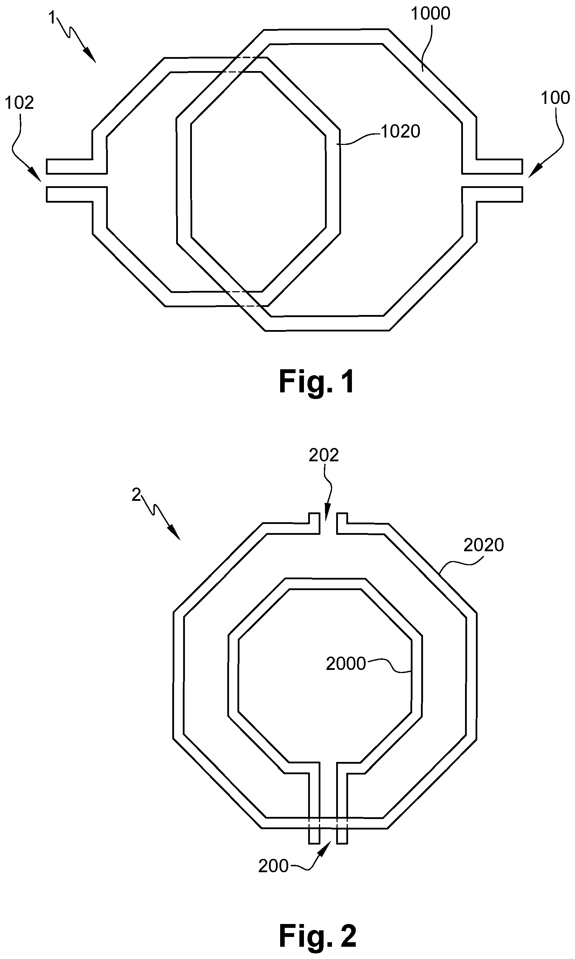

Figure 1 illustrates, by a schematic top view, an example of a transformer 1 having a value of a coupling coefficient K between a primary 100 and a secondary 102 of the transformer 1 equal to a target value.

The primary coil 100 of the transformer 1 comprises only one winding or loop 1000. The winding 1000 of the coil 100 is arranged in a first plan, or, said in other words, in a first layer. For example, the winding 1000 is arranged in a first layer of metal of an interconnexion structure of an integrated circuit.

Similarly, the secondary coil 102 of the transformer 1 comprises only one winding or loop 1020. The winding 1020 of the coil 102 is arranged in a second plan, or, said in other words, in a second layer. The first plan (or layer) and the second plan (or layer) are parallel the one with the other. For example, the winding 1020 is arranged in a second layer of metal of the interconnexion structure.

The winding 1000 of the primary coil 100 is configured for generating a magnetic field in a direction perpendicular to the first plan. For example, in the first plan, the magnetic field is generated by the coil 100 in a direction perpendicular to the first plane.

The winding 1020 of the secondary coil 102 is configured for generating a magnetic field in a direction perpendicular to the second plan. For example, in the second plan, the magnetic field is generated by the coil 102 in a direction perpendicular to the second plane.

Although not represented in figure 1, when the two windings 1000 and 1020 are concentric, the value of the coupling coefficient K between the coils 100 and 102 is maximal. The value of K is adapted, for example decreased, for example in absolute value, with respect to the maximal value of K, by sliding, in a direction parallel to the first and second plans, the winding 1000 with respect to the winding 1020, without changing the dimensions of each of the windings 1000 and 1020. A drawback of adapting the value of K by sliding the winding 1000 with respect to the winding 1020 is that the area occupied by the transformer is increased with respect to the case where the windings 1000 and 1020 are concentric.

Figure 2 illustrates, by a schematic top view, another example of a transformer 2 having a value of a coupling coefficient K between a primary 200 and a secondary 202 of the transformer 2 equal to a target value.

The primary coil 200 of the transformer 2 comprises only one winding or loop 2000. The winding 2000 of the coil 200 is arranged in a first plan, or, said in other words, in a first layer. For example, the winding 2000 is arranged in a first layer of metal of an interconnexion structure of an integrated circuit.

Similarly, the secondary coil 202 of the transformer 2 comprises only one winding or loop 2020. The winding 2020 of the coil 202 is arranged in a second plan, or, said in other words, in a second layer. The first plan (or layer) and the second plan (or layer) are parallel the one with the other. The first and second plans can be coplanar or may be different the one from the other. For example, the winding 2020 is arranged in a second layer of metal of the interconnexion structure, which can be the same as the first layer of metal or different from the first layer of metal.

The winding 2000 of the primary coil 200 is configured for generating a magnetic field in a direction perpendicular to the first plan. For example, in the first plan, the magnetic field is generated by the coil 200 in a direction perpendicular to the first plane.

The winding 2020 of the secondary coil 202 is configured for generating a magnetic field in a direction perpendicular to the second plan. For example, in the second plan, the magnetic field is generated by the coil 202 in a direction perpendicular to the second plane.

The two windings 2000 and 2020 are concentric.

In the transformer 2, the value of K is adapted by changing the dimensions (for example the diameter) of the winding 2000 or the dimensions (for example the diameter) of the winding 2020 or the dimensions (for example the diameters) of both the winding 2000 and the winding 2020, so that an intersecting area of the two coils 200 and 202 is changed. However, changing the dimensions of the outermost winding (the winding 2020 in the example of figure 2) will change the area of the transformer. Further, changing the dimensions of the coil 200, respectively 202, will change the impedance value of the coil 200, respectively 202, and, thus, of the resonant frequencies of the transformer 2.

In order to address at least some of the drawbacks of known transformers, for example of known transformers of the types described in relation with figures 1 and 2, in which the value of the coefficient of coupling between the primary and secondary is equal to a target value, for example lower than 1, a transformer is here provided.

In the provided transformer, one of a primary coil and a secondary coil comprises at least one first winding configured to generate a magnetic field in a first direction and at least one second winding configured to generate a magnetic field in a second direction opposite to the first direction. Further, the first and second windings are coplanar, or, said in other words, are arranged in a same plan, the first and second directions being perpendicular to this plan. For example, in this plan, the first and second windings have together a general 8-shape, preferably asymmetrical. For example, an 8-shaped coil is said to be asymmetrical when a first surface laterally delimited by a first loop (first winding(s)) of the 8-shaped coil occupies a percentage of the total surface of the first coil that is comprised in the range from 5% to 45% or in the range from 55% to 95%, for example in the range from 5% to 40% or in the range from 60% to 95%, preferably in the range from 5% to 35% or in the range from 65% to 95%. For example, when the at least one first winding comprises a plurality of first windings, these first windings are concentric with each other, and when the at least one second winding comprises a plurality of second windings, these second windings are concentric with each other.

By changing a ratio between a surface laterally delimited by the first winding(s) and a surface laterally delimited by the second winding(s), the value of the coupling coefficient between the primary and secondary coils is changed, advantageously without changing the area of the transformer and the inductance values of the coils.

For example, the other one of the primary and secondary coils may be arranged in a plan parallel to the plan the first and second windings are arranged in, these two plans being coplanar, or, alternatively, different from each other.

For example, when the windings of the two coils are arranged in the same plan, an area occupied by one of these two coils is, for example, included in an area occupied by the other one of these two coils, these two areas being sensibly equal. Said in other words, one of the two coils is arranged in a surface laterally delimited by the other one of these two coils. Said in further other words, the surface (or area) occupied by one of the two coils is included in the surface (or area) occupied by the other one of the two coils, and these two surfaces are sensibly equal to each other. Further, the two coils have sensibly the same footprint, or, said in other words, the footprint of one of the two coils projected on the above-mentioned same plan is sensibly the same as the footprint of the other one of the two coils projected on this plan.

For example, when the windings of the two coils are arranged in different parallel plans, the area occupied by one of the two coils is, for example, equal or sensibly equal to the area occupied by the other one of the two coils, and these two areas are facing each other in a direction parallel to the first and second direction. Further, the footprint of one of the two coils projected on a projection plan parallel to the above-mentioned different parallel plans is identical to the footprint of the other one of the two coils projected on the projection plan.

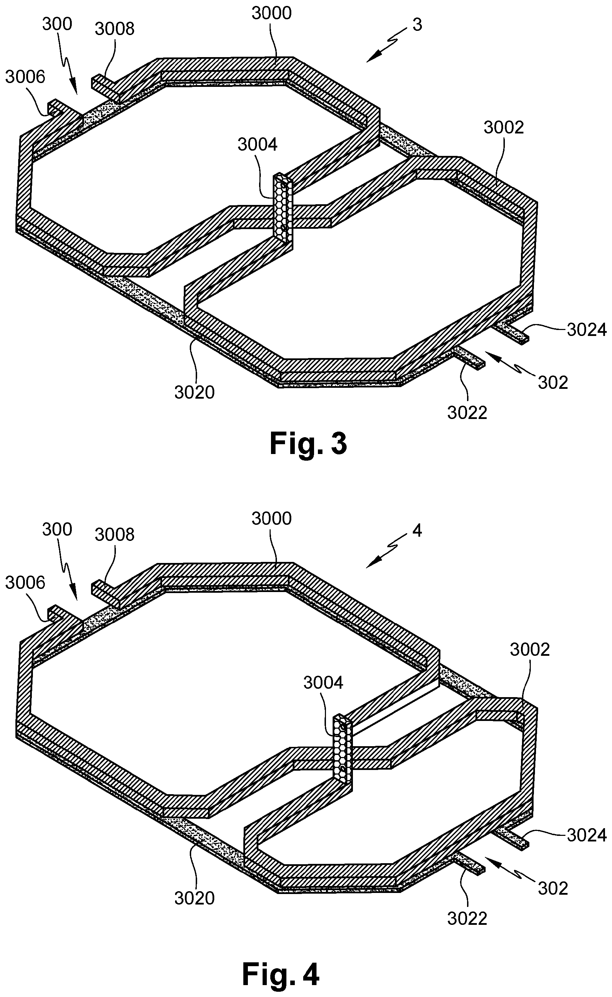

Different examples of embodiment of such an advantageous transformer will be described in relation with the figures 3 to 11.

Figure 3 illustrates, by a schematic tri-dimensional view, an example of an embodiment of a transformer 3 having a value of the coupling coefficient between the primary and the secondary of the transformer equal to a target value.

The transformer 3 comprises a first coil 300 and a second coil 302 corresponding to the primary and the secondary of the transformer 3. For example, the coil 300, respectively 302, is the primary, respectively the secondary, of the transformer 3, although, in alternative examples the coil 300, respectively 302, is the secondary, respectively the primary, of the transformer 3.

The coil 300 comprises at least one winding or loop 3000 and at least one winding or loop 3002. In the example of figure 3, the coil 300 comprises only one winding 3000 and only one winding 3002.

The winding 3000 and 3002 are arranged in a same first plan. The winding 3000 is configured for generating a magnetic field in a first direction perpendicular to the first plan. For example, in the first plan, the magnetic field generated by the winding 3000 is oriented according to the first direction. The winding 3002 is configured for generating a magnetic field in a second direction perpendicular to the first plan, and opposite to the first direction. For example, in the first plan, the magnetic field generated by the winding 3002 is oriented according to the second direction. The windings 3000 and 3002 taken together, or, said other words, the coil 300, have an 8-shape. In the example of figure 3, the coil 300 is, for example, said to be of the dual coplanar loop type.

For example, the windings 3000 and 3002 are arranged in a first metal layer. For example, the windings 3000 and 3002 are connected to each other by a metallic portion 3004 of a second metal layer. For example, the second metal layer is arranged above the first metal layer in the example of figure 3, although, in alternative examples, the second metal layer could be arranged below the first metal layer. For example, the portion 3004 is connected to the windings 3000 and 3002 by conductive via extending from the first metal layer to the second metal layer. For example, a first half of the winding 3000 connects a first terminal 3006 of the coil 300 to a first extremity of the winding 3002, the portion 3004 connects a second extremity of the winding 3002 to a second half of the winding 3000, the second half of the winding 3000 being connected to a second terminal 3008 of the coil 300.

In the example of the figure 3, the coil 302 comprises at least one winding or loop 3020. In the example of figure 3, the coil 302 comprises only one winding 3020.

The winding 3020 is arranged in a second plan that is parallel to the first plan. The winding 3020 is configured for generating a magnetic field in a third direction perpendicular to the second plan. For example, in the second plan, the magnetic field generated by the winding 3000 is oriented according to the third direction. The third direction is, for example, the same as the first direction, or, in alternative examples, the same as the second direction.

In the example of figure 3, the coil 302 does not comprises further winding(s) arranged in the second plan and configured to generate a magnetic field in a direction opposite to the third direction. The windings 3020 or, said other words, the coil 302, do not have an 8-shape, but instead, for example, an O-shape. Said in other words, in the example of figure 3, the coil 302 is not of the dual coplanar loop type. Instead, the coil 302 is, for example, said to be of the single loop type.

In the example of figure 3, the first and second plans are different, or, said in other words, are not coplanar. For example, as illustrated in figure 3, the first plan is disposed above the second plan although, in alternative examples not illustrated, the first plan is disposed below the second plan.

For example, the winding 3020 is arranged in a third metal layer. In the example of figure 3, the coil 300 is disposed above the coil 302, and the third metal layer is thus disposed below the first metal layer. In an alternative example not shown, the coil 302 is disposed above the coil 300, and the third metal layer is disposed above the first metal layer and, for example, corresponds to the second metal layer comprising the portion 3004. The winding 3020 couples, for example connects in the example of figure 3, the two terminals 3022 and 3024 of the coil 302.

For example, when the first and second plans are different, or, said in other words, when the coils 300 and 302 are disposed the one above the other, in the second plan, a third surface laterally delimited by the winding 3020 comprises a first part facing, in a direction perpendicular to the first and second plans, the first surface laterally delimited by the winding 3000 and a second part facing, in the direction perpendicular to the first and second plans, the second surface laterally delimited by the winding 3002.

Preferably, when the first and second plans are different, an area (or surface) occupied by the coil 300 is the same, or sensibly the same, as an area (or surface) occupied by the coil 302, these two surfaces being facing each other and being aligned in the first direction. Said in other words, the footprint of the coil 300 projected on a plan parallel to the first and second plans is the same as the footprint of the coil 302 projected on this plan parallel to the first and second plans.

In the example of figure 3, in the first plan, a ratio between a first surface laterally delimited by the winding 3000 and a second surface laterally delimited by the winding 3002 is equal to 1**.** Said in other words, the first surface is equal to the second surface. Thus, the K ratio between coils 300 and 302 is minimal, and, for example, equal to 0 in an ideal scenario.

In the example of figure 3, the coil 300 comprises only one winding 3000 and only one winding 3002. In other examples, the coil 300 comprises a plurality of concentric windings 3000 and a plurality of concentric windings 3002, the number of winding 3000 being then equal to the number of winding 3002. More generally, in further other examples, the number of winding 3000 could be different from the number of winding 3002.

In the example of figure 3, the coil 302 comprises only one winding 3020. In other examples, the coil 302 comprises a plurality of concentric windings 3020.

In the example of figure 3, the coils 300 and 302 are disposed the one above the other. In other examples, the coils 300 and 302 are coplanar, or, said in other words, the windings 3000, 3002 and 3020 are arranged in the same first plane. Said in further other words, in other examples not shown, the first and second plans are coplanar. In such other examples, the coil 302 may be disposed inside a surface laterally delimited by the coil 300, or, the coil 300 may be disposed inside a surface laterally delimited by the coil 302.

When the first and second plans are coplanar, although not shown in figure 3, the third surface laterally delimited by the winding 3020 comprises a first part included in the first surface laterally delimited by the winding 3000, and a second part included in the second surface laterally delimited by the winding 3002. Said in other words, the first part of the third surface corresponds to at least a portion of the first surface, and the second part of the third surface corresponds to at least a portion of the second surface.

Figure 4 illustrates, by a schematic tri-dimensional view, an example of an embodiment of a transformer 4 having a value of the coupling coefficient between the primary and the secondary of the transformer 4 equal to a target value.

The transformer 4 is similar to the transformer 3 and comprises a lot of elements in common with the transformer 3. Thus, only the differences between the transformers 3 and 4 are here detailed. For example, unless indicated otherwise, everything that has been disclosed for the transformer 3 applies to the transformer 4**.**

The transformer 4 differs from the transformer 3 in that the ratio between the first surface delimited by the winding 3000 of the coil 300 and the second surface delimited by the winding 3002 of the coil 300 is not equal to one. More particularly, the coil 300 is 8-shaped and asymmetrical. Thus, the value of the coupling coefficient K between the primary and the secondary of the transformer 4 differs from the value of the coupling coefficient K between the primary and the secondary of the transformer 3. In the transformer 4, the ratio between the first surface delimited by the winding 3000 of the coil 300 and the second surface delimited by the winding 3002 of the coil 300 is determined by a target value of the coupling coefficient K. More particularly, the ratio between the first surface delimited by the winding 3000 of the coil 300 and the second surface delimited by the winding 3002 of the coil 300 is determined so that the value of the coupling coefficient between the primary and the secondary of the transformer 4 is equal to the target value.

For example, in the figure 4, the coupling coefficient K is proportional to (S1a-S1b)/S2, where S1a is the surface laterally delimited by the winding 3000, S1b is the surface laterally delimited by the winding 3002, and S2 is the surface laterally delimited by the winding 3020.

In figure 4, a first surface equal to an intersection of a projection, on a projection plan parallel to the plan the coil 300 is arranged in and the plan the coil 302 is arranged in, of the surface laterally delimited by the winding 3020 with a projection, on the projection plan, of the surface laterally delimited by the winding 3000, is different from a second surface equal to an intersection of a projection, on the projection plan, of the surface laterally delimited by the winding 3020 with a projection, on the projection plan, of the surface laterally delimited by the winding 3002, the first and second surfaces being not null. Further, a third surface equal to an intersection of the projection, on the projection plan, of the surface laterally delimited by the winding 3000, with the projection, on the projection plan, of the surface laterally delimited by the winding 3002, is null.

As it can be seen on figures 3 and 4, the area of the transformer 4 does not need to be modified with respect to the area of the transformer 3 to adapt the value of the coupling coefficient K. Moreover, as the total length of the coil 300, respectively 302, is not modified between the two transformer 3 and 4, the inductance value of the coil 300, respectively 302, is not modified between the two transformers 3 and 4.

For example, during the conception of an integrated circuit comprising the transformer 3 or 4, if at the end of the conception, before the fabrication, for example in a phase of analog validation of the circuit, it appears that the target value of the transformer should be modified, for example in order to adapt the bandwidth and the resonant frequencies of the transformer used a balun between a load and a source, this could be done by a simple modification of the layout of the transformer. This simple modification of the layout consists in modifying the ratio between the first surface delimited by the winding 3000 and the second surface delimited by the winding 3002, without changing the area of the transformer, and without changing the impedance value of the coil 300. Thus, the rest of the circuit advantageously does not need to be modified.

In the example embodiments described in relation with figure 3 and 4, the coil 302 is not of the dual coplanar loop type, or said in other words, does not have an 8-shape as the coil 300.

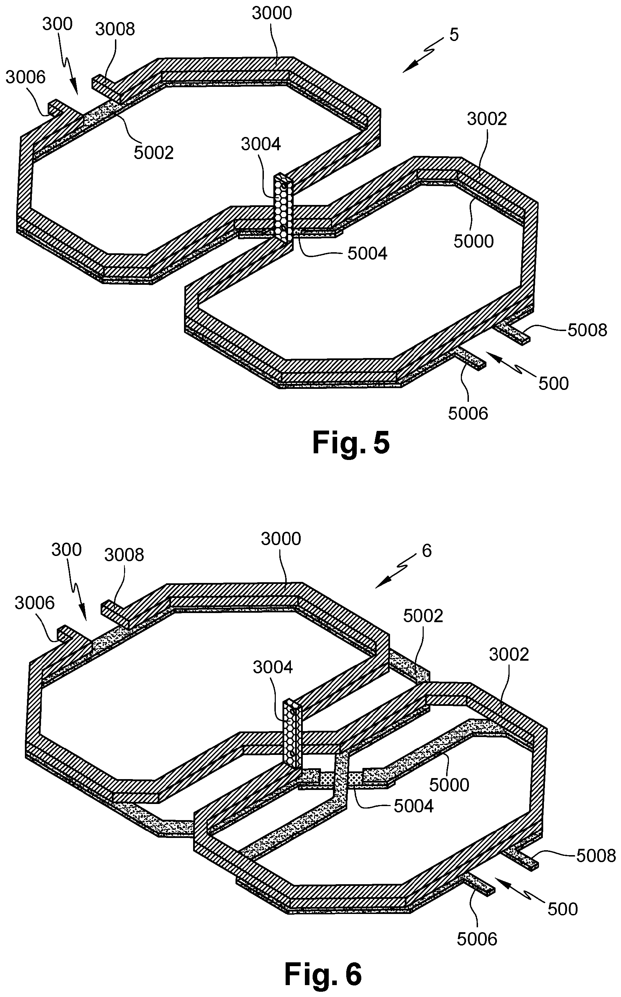

However, the coil 302 could be similar to the coil 300, and be of the dual coplanar type as it will be described below in relation with figures 5 to 9.

Figure 5 illustrates, by a schematic tri-dimensional view, an example of an embodiment of a transformer 5 having a value of the coupling coefficient between the primary and the secondary of the transformer equal to a target value.

The transformer 5 is similar to the transformer 3 and comprises a lot of elements in common with the transformer 3**.** Thus, only the differences between the transformers 3 and 5 are here detailed. For example, unless indicated otherwise, everything that has been disclosed for the transformer 3 applies to the transformer 5.

The transformer 5 differs from the transformer 3 in that the coil 302 is replaced by a coil 500.

The coil 500 comprises at least one winding or loop 5000 and at least one winding or loop 5002. In the example of figure 5, the coil 500 comprises only one winding 5000 and only one winding 5002.

The winding 5000 and 5002 are arranged in a same second plan. In the example of figure 5, the first and second plans are not coplanar, or, said in other words, are different from each other. The winding 5000 is configured for generating a magnetic field in a third direction perpendicular to the first plan. For example, in the second plan, the magnetic field generated by the winding 5000 is oriented according to the third direction. The winding 5002 is configured for generating a magnetic field in a fourth direction perpendicular to the second plan, and opposite to the third direction. For example, in the second plan, the magnetic field generated by the winding 5002 is oriented according to the fourth direction. The windings 5000 and 5002 taken together, or, said other words, the coil 500, have an 8-shape. In the example of figure 5, the coil 300 is, for example, said to be of the dual coplanar loop type.

For example, the windings 5000 and 5002 are arranged in a third metal layer. For example, the windings 5000 and 5002 are connected to each other by a metallic portion 5004 of a fourth metal layer.

For example, in the figure 5 where the coil 300 is disposed above the coil 500, the third metal layer is disposed below the first metal layer of the windings 3000 and 3002. For example, in the example of figure 5, the second metal layer of the portion 3004 is disposed above the first metal layer. For example, in the example of figure 5, the fourth metal layer of the portion 5004 is disposed below the third layer of the windings 5000 and 5002. However, in alternative examples not shown where the coil 500 is disposed above the coil 300, the fourth metal layer of potion 5004 may be disposed above the third metal layer of the windings 5000 and 5002, the third metal layer is disposed above the first metal layer of the windings 3000 and 3002, and the first metal layer may be disposed above the second metal layer of the portion 3004. For example, the portion 5004 is connected to the windings 5000 and 5002 by conductive via extending from the third metal layer to the fourth metal layer. For example, a first half of the winding 5000 connects a first terminal 5006 of the coil 500 to a first extremity of the winding 5002, the portion 5004 connects a second extremity of the winding 5002 to a second half of the winding 5000, the second half of the winding 5000 being connected to a second terminal 5008 of the coil 500.

Preferably, when the first and second plans are different, an area (or surface) occupied by the coil 300 is the same, or sensibly the same, as an area (or surface) occupied by the coil 500, these two surfaces being facing each other and being aligned in the first direction. Said in other words, the footprint of the coil 300 projected on a plan parallel to the first and second plans is the same as the footprint of the coil 500 projected on this plan parallel to the first and second plans.

In the example of figure 5, in the first plan, the ratio between the first surface laterally delimited by the winding 3000 and the second surface laterally delimited by the winding 3002 is equal to 1, and, further, in the second plan, a ratio between the third surface laterally delimited by the winding 5000 and the fourth surface laterally delimited by the winding 5002 is equal to 1. Said in other words, the first surface is equal to the second surface, and the third surface is equal to the fourth surface. In the example of figure 6, the first surface is entirely facing the fourth surface in a direction perpendicular to the first and second plans, and the second surface is entirely facing the third surface in a direction perpendicular to the first and second plans.

Thus, in the example of figure 5, the coupling coefficient has a maximal value, for example, in absolute value. Thus, in figure 5, the target value of the coupling coefficient is equal to the maximum value that the coupling coefficient may have in a transformer of the type described in relation with figure 5, where the coils 300 and 500 are each of the dual coplanar loop type and the coils 300 and 500 are disposed the one above the other.

Figure 6 illustrates, by a schematic tri-dimensional view, an example of an embodiment of a transformer 6 having a value of the coupling coefficient between the primary and the secondary of the transformer 6 equal to a target value.

The transformer 6 is similar to the transformer 5 and comprises a lot of elements in common with the transformer 5. Thus, only the differences between the transformers 5 and 6 are here detailed. For example, unless indicated otherwise, everything that has been disclosed for the transformer 5 applies to the transformer 6.

The transformer 6 differs from the transformer 5 in that, in one of the coils 300 and 500, the ratio between the surface delimited by the winding of this coil configured for generating a magnetic field in a direction perpendicular to the plan the windings of this coil are arranged in, and the surface delimited by the other winding this coil configured for generating another magnetic field in another direction perpendicular to the plan the windings of this coil is not equal to one. Thus, the value of the coupling coefficient K between the primary and the secondary of the transformer 6 differs from the value of the coupling coefficient K between the primary and the secondary of the transformer 5.

In the example of figure 6, the ratio between the third surface delimited by the winding 5000 and the fourth surface delimited by the winding 5002 is not equal to one, whereas the ratio between the first surface delimited by the winding 3000 and the second surface delimited by the winding 3002 is equal to one. In the transformer 6, the ratio between the third and fourth surfaces is determined by a target value of the coupling coefficient K. More particularly, the ratio between the third and fourth surfaces is determined so that the value of the coupling coefficient between the primary and the secondary of the transformer 6 is equal to the target value.

For example, in the figure 6, the coupling coefficient K is proportional to 1-((S1a-S1b)/(S2a-S2b), where S1a is the surface laterally delimited by the winding 3000, S1b is the surface laterally delimited by the winding 3002, S2a is the surface laterally delimited by the winding 5000 and S2b is the surface laterally delimited by the winding 5002.

In figure 6, a first surface equal to an intersection of a projection, on a projection plan parallel to the first and second plans, of the surface laterally delimited by the winding 3000 with a projection, on the projection plan, of the surface laterally delimited by the winding 5002, is different from a second surface equal to an intersection of a projection, on the projection plan, of the surface laterally delimited by the winding 3002 with a projection, on the projection plan, of the surface laterally delimited by the winding 5002, the first and second surfaces being not null. Further, a third surface equal to an intersection of the projection, on the projection plan, of the surface laterally delimited by the winding 3000, with the projection, on the projection plan, of the surface laterally delimited by the winding 3002, is null.

As it can be seen on figures 5 and 6, the area of the transformer 6 does not need to be modified with respect to the area of the transformer 5 to adapt the value of the coupling coefficient K. Moreover, as the total length of the coil 300, respectively 500, is not modified between the two transformers 5 and 6, the inductance value of the coil 300, respectively 500, is not modified between the two transformers 5 and 6.

Advantageously, the value of the coefficient K may be modified in the transformer 6 with respect to the transformer 5 with simple modification of the layout consisting in modifying the ratio between the third and fourth surfaces, without changing the area of the transformer, and without changing the impedance values of the respective coils 300 and 500.

In the example of figure 6, the value of the coefficient K is modified by modifying the ratio between the third and fourth surfaces and without modifying the ratio between the first and second surfaces. Preferably, the greatest of the third and fourth surfaces then comprises a first part facing, in a direction perpendicular to the first and second plans, the first surface and a second part facing, in the direction perpendicular to the first and second plans, the second surface.

In alternative examples, the value of the coefficient K is modified by modifying the ratio between the first and second surfaces and without modifying the ratio between the third and fourth surfaces. Preferably, the greatest of the first and second surfaces then comprises a first part facing, in a direction perpendicular to the first and second plans, the third surface and a second part facing, in the direction perpendicular to the first and second plans, the fourth surface.

In both alternative examples of transformer 6 described above, the connection region between the winding 3000 and 3002 and the connection region are not disposed the one above the other. Thus, although in figure 6 the portion 3004 is disposed in a second metal layer above the first metal layer of the windings 3000 and 3002, in other examples, the portion 3004 may be disposed in a second metal layer below the first metal layer, and this second metal layer may then be the same as the second metal layer of the windings 5000 and 5002. Similarly, although in figure 6 the portion 5004 is disposed in a fourth metal layer below the third metal layer of the windings 5000 and 5002, in other examples, the portion 5004 may be disposed in a fourth metal layer above the first metal layer, and this fourth metal layer may then be the same as the first metal layer of the windings 3000 and 3002.

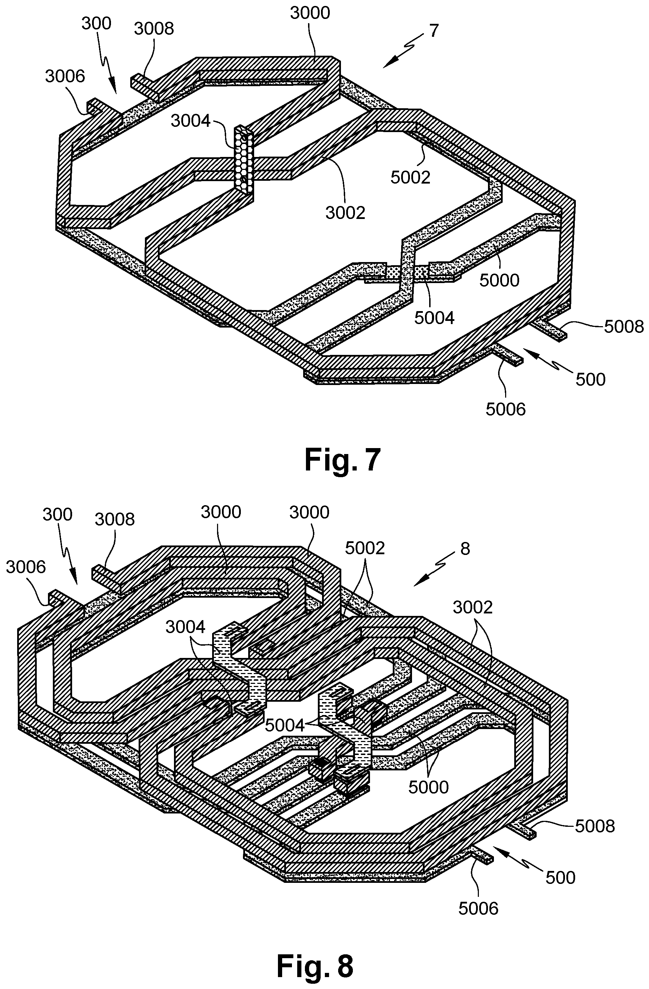

Figure 7 illustrates, by a schematic tri-dimensional view, an example of an embodiment of a transformer 7 having a value of the coupling coefficient between the primary and the secondary of the transformer 7 equal to a target value.

The transformer 7 is similar to the transformer 6 and comprises a lot of elements in common with the transformer 6**.** Thus, only the differences between the transformers 6 and 7 are here detailed. For example, unless indicated otherwise, everything that has been disclosed for the transformer 6 applies to the transformer 7.

The transformer 7 differs from the transformer 6 in that, in each of the coils 300 and 500, the ratio between the surface delimited by the winding of this coil configured for generating a magnetic field in a direction perpendicular to the plan the windings of this coil are arranged in, and the surface delimited by the other winding of this coil configured for generating another magnetic field in another direction perpendicular to the plan the windings of this coil are arranged in, is not equal to one. Thus, the value of the coupling coefficient K between the primary and the secondary of the transformer 7 differs from the value of the coupling coefficient K between the primary and the secondary of the transformer 5 and from the value of the coupling coefficient between the primary and the secondary of the transformer 6**.**

In the example of figure 7, the ratio between the third surface delimited by the winding 5000 and the fourth surface delimited by the winding 5002 is not equal to one, and, further, the ratio between the first surface delimited by the winding 3000 and the second surface delimited by the winding 3002 is not equal to one. In the transformer 7, the ratio between the third and fourth surfaces, and the ratio between the first and second surfaces are determined by a target value of the coupling coefficient K. More particularly, the ratio between the third and fourth surfaces and the ratio between the first and second surfaces are determined so that the value of the coupling coefficient between the primary and the secondary of the transformer 7 is equal to the target value.

In figure 7, as in figure 6, first surface equal to an intersection of a projection, on a projection plan parallel to the first and second plans, of the surface laterally delimited by the winding 3000 with a projection, on the projection plan, of the surface laterally delimited by the winding 5002, is different from a second surface equal to an intersection of a projection, on the projection plan, of the surface laterally delimited by the winding 3002 with a projection, on the projection plan, of the surface laterally delimited by the winding 5002, the first and second surfaces being not null. Further, a third surface equal to an intersection of the projection, on the projection plan, of the surface laterally delimited by the winding 3000, with the projection, on the projection plan, of the surface laterally delimited by the winding 3002, is null.

As it can be seen on figures 5, 6 and 7, the area of the transformer 6 does not need to be modified with respect to the area of the transformers 5 and 6 to adapt the value of the coupling coefficient K. Moreover, as the total length of the coil 300, respectively 500, is not modified between the transformers 5, 6 and 7, the inductance value of the coil 300, respectively 500, is not modified between the transformers 5, 6 and 7.

Advantageously, the value of the coefficient K may be modified in the transformer 7 with respect to the transformer 5 with simple modification of the layout consisting in modifying the ratio between the third and fourth surfaces and the ration between the first and second surfaces, without changing the area of the transformer, and without changing the impedance values of the respective coils 300 and 500.

Preferably, in the transformer 7 where the coils 300 and 500 are disposed the one above the other, the greatest of the first surface laterally delimited by the winding 3000 and of the second surface laterally delimited by the winding 3002 comprises a first part facing, in a direction perpendicular to the first and second plans, the third surface delimited by the winding 5000 and a second part facing, in this direction perpendicular to the first and second plans, the fourth surface delimited by the winding 5002. Said in other words, in the transformer 7, the connection region between the winding 3000 and 3002 and the connection region are not disposed the one above the other.

Thus, although in figure 7 the portion 3004 is disposed in a second metal layer above the first metal layer of the windings 3000 and 3002, in other examples, the portion 3004 may be disposed in a second metal layer below the first metal layer, and this second metal layer may then be the same as the second metal layer of the windings 5000 and 5002. Similarly, although in figure 7 the portion 5004 is disposed in a fourth metal layer below the third metal layer of the windings 5000 and 5002, in other examples, the portion 5004 may be disposed in a fourth metal layer above the first metal layer, and this fourth metal layer may then be the same as the first metal layer of the windings 3000 and 3002.

In the example of figures 5, 6 and 7, the coil 300 comprises only one winding 3000 and only one winding 3002. In other examples, the coil 300 comprises a plurality of concentric windings 3000 and a plurality of concentric windings 3002, the number of winding 3000 being then equal to the number of winding 3002. More generally, in further other examples, the number of winding 3000 could be different from the number of winding 3002.

In the example of figures 5, 6 and 7, the coil 500 comprises only one winding 5000 and only one winding 5002. In other examples not illustrated, the coil 500 comprises a plurality of concentric windings 5000 and a plurality of concentric windings 5002, the number of winding 5000 being then equal to the number of winding 5002. More generally, in further other examples, the number of winding 5000 could be different from the number of winding 5002.

In the example figures 5, 6 and 7, the coils 300 and 500 are disposed the one above the other. In other examples not illustrated, the coils 300 and 500 are coplanar, or, said in other words, the windings 3000, 3002, 5000 and 5002 are arranged in the same first plane. Said in further other words, in other examples not shown, the first and second plans are coplanar. Preferably, in such examples, when the ratio of the first and second surfaces is not equal to one, the greatest of the first and second surfaces comprises a first part corresponding to a part of the third surface and a second part corresponding to a part of the fourth, and, when the ratio of the third and fourth surfaces is not equal to one, the greatest of the third and fourth surfaces comprises a first part corresponding to a part of the first surface and a second part corresponding to a part of the second surface.

Figure 8 illustrates, by a schematic tri-dimensional view, an example of an embodiment of a transformer 8 having a value of the coupling coefficient between the primary and the secondary of the transformer equal to a target value.

The transformer 8 is similar to the transformer 7 and comprises a lot of elements in common with the transformer 7. Thus, only the differences between the transformers 8 and 7 are here detailed. For example, unless indicated otherwise, everything that has been disclosed for the transformer 7 applies to the transformer 8.

The transformer 8 differs from the transformer 7 in that the coil 300 comprises a plurality of concentric windings 3000 and a plurality of concentric windings 3002. For example, in figure 8, the coil 300 comprises two concentric windings 3000 and two concentric windings 3002, although, in other examples, the number of concentric windings 3000 and the number of concentric windings 3002, which are equal to each other, may be superior to two.

The windings 3000 and 3002 are arranged in the first plan. Further, the concentric windings 3000 are configured for generating a magnetic field in a first direction perpendicular to the first plan. For example, in the first plan, the magnetic field generated by the windings 3000 is oriented according to the first direction. The concentric windings 3002 are configured for generating a magnetic field in a second direction perpendicular to the first plan, and opposite to the first direction. For example, in the first plan, the magnetic field generated by the windings 3002 is oriented according to the second direction. The windings 3000 and 3002 taken together, or, said other words, the coil 300, have an 8-shape and the coil is, for example, said to be of the dual coplanar loop type.

For example, the windings 3000 and 3002 are arranged in a first metal layer.

For example, the windings 3000 and 3002 are connected to each other by a metallic portion 3004 of at least one second metal layer.

For example, in the example of figure 8, a portion 3004 is arranged in a second metal layer disposed above the first metal layer and another portion 3004 is disposed in another second metal layer disposed below the first metal layer. In this example where the coil 300 is disposed above the coil 500, the second metal layer disposed below the first metal layer of the windings 3000 and 3002 may correspond to the third metal layer of the winding 5000 and 5002 of the coil 500. However, the disposition of the portion 3004 with respect to each other and to the first metal layer may be different from that is shown by figure 8.

In the first plan, the first surface is laterally delimited by the concentric windings 3000, and the second surface is laterally delimited by the concentric windings 3002.

The transformer 8 further differs from the transformer 7 in that the coil 500 comprises a plurality of concentric windings 5000 and a plurality of concentric windings 5002. For example, in figure 8, the coil 500 comprises two concentric windings 5000 and two concentric windings 5002, although, in other examples, the number of concentric windings 5000 and the number of concentric windings 5002, which are equal, may be superior to two. Further, the number of windings 5000 may be different from the number of windings 3000, although, in the example of figure 8, the number of windings 5000 is equal to the number of windings 3000.

The windings 5000 and 5002 are arranged in the second plan. Further, the concentric windings 5000 are configured for generating a magnetic field in a third direction perpendicular to the first and second plans. For example, in the second plan, the magnetic field generated by the windings 5000 is oriented according to the third direction. The concentric windings 5002 are configured for generating a magnetic field in a fourth direction perpendicular to the first and second plans, and opposite to the third direction. For example, in the second plan, the magnetic field generated by the windings 5002 is oriented according to the fourth direction. The windings 5000 and 5002 taken together, or, said other words, the coil 500, have an 8-shape and the coil is, for example, said to be of the dual coplanar loop type.

For example, the windings 5000 and 5002 are arranged in a third metal layer.

For example, the windings 5000 and 5002 are connected to each other by a metallic portion 5004 of at least one fourth metal layer.

For example, in the example of figure 8, a portion 5004 is arranged in a first fourth metal layer disposed above the third metal layer and another portion 5004 is disposed in second fourth metal layer disposed above the first fourth metal layer. In this example where the coil 300 is disposed above the coil 500, the first fourth metal layer disposed above the third metal layer of the windings 5000 and 5002 may correspond to the first metal layer of the winding 3000 and 3002 of the coil 500, and the second fourth metal layer may correspond to second metal layer disposed above the first metal layer. However, the disposition of the portion 5004 with respect to each other and to the third metal layer may be different from that is shown by figure 8.

In the second plan, the third surface is laterally delimited by the concentric windings 5000, and the fourth surface is laterally delimited by the concentric windings 5002.

In the example of figure 8, as in figure 7, the ratio between the first and second surfaces is not equal to one and the ratio between the third and fourth surfaces is not equal to one. Further, these two ratios are determined such that the value of the coupling coefficient K is equal to a target value.

In an alternative example, the ratio between the first and second surfaces is not equal to one and the ratio between the third and fourth surfaces is equal to one. Further, the ratio between the first and second surfaces is determined such that the value of the coupling coefficient K is equal to a target value.

In another alternative example, the ratio between the first and second surfaces is equal to one and the ratio between the third and fourth surfaces is not equal to one. Further, the ratio between the third and fourth surfaces is determined such that the value of the coupling coefficient K is equal to a target value.

In the example of figure 8 the coil 300 comprises a plurality of windings 3000 and a plurality of windings 3002 and the coil 500 comprises a plurality of windings 5000 and a plurality of windings 5002. In alternative examples the coil 300 comprises a plurality of windings 3000 and a plurality of windings 3002 and the coil 500 comprises only one winding 5000 and only one winding 5002. In other alternative examples, the coil 300 comprises only one winding 3000 and only one winding 3002 and the coil 500 comprises a plurality of windings 5000 and a plurality of windings 5002.

Further, those skilled in the art will be able to replace, in the transformers 3 and 4 of figures 3 and 4 the coil 300 with only one winding 3000 and only one winding 3002 by a coil 300 with a plurality of windings 3000 and a plurality of windings 3002.

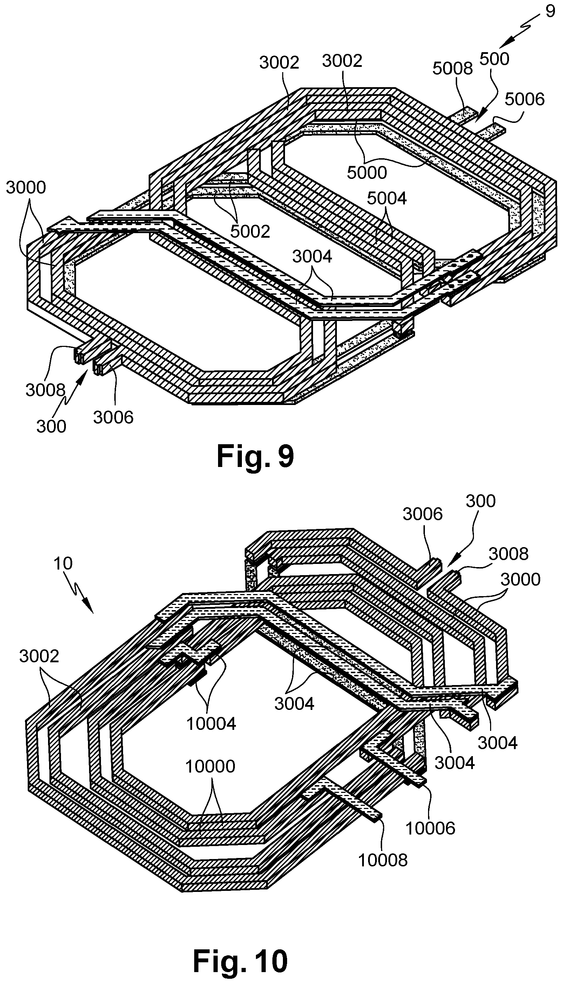

Figure 9 illustrates, by a schematic tri-dimensional view, an example of an embodiment of a transformer 9 having a value of the coupling coefficient between the primary and the secondary of the transformer equal to a target value.

The transformer 9 is similar to the transformer 8 and comprises a lot of elements in common with the transformer 8. Thus, only the differences between the transformers 9 and 8 are here detailed. For example, unless indicated otherwise, everything that has been disclosed for the transformer 8 applies to the transformer 9.

The transformer 9 differs from the transformer 8 in that the portions 3004 connecting the windings 3000 and 3002 together are longer in the transformer 9 than in the transformer 8. Changing the length of the portions 3004 allows for changing the value of parasitic capacitance between the winding 3000 and 3002. Thus, according to one embodiment, where the windings 3000 and 3002 are connected to each other by at least one metallic portion 3004 arranged in at least one second metal layer different from the first metal layer of the windings 3000 and 3002, and the length of the portions 3004 is determined by a target value of the parasitic capacitance between the windings 3000 and 3002.

In the example of figure 9, the portions 3004 are all arranged in the same second metal layer, although, in other examples, two different portions 3004 may be arranged in two different second metal layers, as it has been for example illustrated on figure 8.

The transformer 9 differs from the transformer 8 in that the portions 5004 connecting the windings 5000 and 5002 together are longer in the transformer 9 than in the transformer 8. Changing the length of the portions 5004 allows for changing the value of parasitic capacitance between the winding 5000 and 5002. Thus, according to one embodiment, where the windings 5000 and 5002 are connected to each other by at least one metallic portion 5004 arranged in at least one fourth metal layer different from the third metal layer of the windings 5000 and 5002, and the length of the portions 5004 is determined by a target value of the parasitic capacitance between the windings 5000 and 5002.

In the example of figure 9, the portions 5004 are all arranged in the same fourth metal layer, which may correspond to the first metal layer of the windings 3000 and 3002 as illustrated in figure 9, although, in other examples, two different portions 5004 may be arranged in two different fourth metal layers, as it has been for example illustrated on figure 8.

Figure 10 illustrates, by a schematic tri-dimensional view, an example of an embodiment of a transformer 10 having a value of the coupling coefficient between the primary and the secondary of the transformer equal to a target value.

The transformer 10 is similar to the transformer 9 and comprises a lot of elements in common with the transformer 9. Thus, only the differences between the transformers 10 and 9 are here detailed. For example, unless indicated otherwise, everything that has been disclosed for the transformer 9 applies to the transformer 10.

The transformer 10 differs from the transformer 9 in that the coil 500 is replaced by a coil 1000, and that the winding(s) of the coil 1000 are arranged in a second plan which is coplanar with the first plan. Thus, the winding(s) of the coil 1000 are coplanar with the winding 3000 and 3002 of the coil 300.

For example, in figure 10, the coil is of the single loop type and comprises a plurality of concentric windings 10000, for example two windings 1000, configured to generate a magnetic field in a direction perpendicular to the first and second plans. For example, the windings 10000 are arranged in a second metal layer which is the same as the first metal layer of the windings 3000 and 3002. For example, between two extremities 10006 and 10008 of the coil 1000, the winding 10000 are connected to each other by at least one metallic portion 10004 arranged in at least one fourth metal layer different from the third metal layer of the windings 10000.

In the figure 10, the ratio between the first surface laterally delimited by the windings 3000 and the second surface laterally delimited by the windings 3002 is determined such that the value of the coupling coefficient is equal to a target value.

In figure 10, a first surface equal to an intersection of a projection, on a projection plan parallel to the plan the coils 300 and 1000 are arranged in, of the surface laterally delimited by the windings 3000 with a projection, on the projection plan, of the surface laterally delimited by the windings 10000, is different from a second surface equal to an intersection of a projection, on the projection plan, of the surface laterally delimited by the windings 3002 with a projection, on the projection plan, of the surface laterally delimited by the windings 10000, the first and second surfaces being not null. Further, a third surface equal to an intersection of the projection, on the projection plan, of the surface laterally delimited by the winding 3000, with the projection, on the projection plan, of the surface laterally delimited by the winding 3002, is null.

Preferably, when a transformer, for example, the transformer 10, comprises a coil 300 of the dual coplanar loop type and a coil 1000 of the single loop type, and that the windings of the coils 300 and 1000 are arranged in the same plan, in this plan, the third surface laterally delimited by the windings 1000 comprises a first part corresponding to a part of the first surface, and a second part corresponding to a part of the second surface.

Those skilled in the art will be able to adapt the example of the figure 10 to other examples where the number of windings 3000 of the coil 300 is different from two, for example equal to one or superior to two. Similarly, those skilled in the art will be able to adapt the example of the figure 10 to other examples where the number of windings 10000 of the coil 100 is different than two, for example equal to one or superior to two.

In the example of the figure 10, the coil 1000 is disposed in an inner surface of the coil 300. Thus, the area occupied by the coil 1000 projected on a plane parallel to the first and second plans is entirely included in the area occupied by the coil 300 projected on this plane parallel to the first and second plans. However, those skilled in the art are capable of adapting the example of figure 10 to other examples where the coil 300 is disposed in an inner surface of the coil 1000. In such other examples, the area occupied by the coil 300 projected on a plane parallel to the first and second plans is entirely included in the area occupied by the coil 1000 projected on this plane parallel to the first and second plans.

In all the examples of embodiments described above in relation with figures 3 to 10, the transformers each comprises only two coils corresponding to the primary and to a first secondary of the transformer. However, all these examples of embodiments may be generalized to the case where the transformer comprises a further coil corresponding to a second secondary of the transformer. More generally, all the above described examples may be generalized to case the where the transformer comprises more than three coils coupled the one with each other.

For example, when adding a third coil in a transformer of the type described in relation with figures 3 to 10, a value of the coupling coefficient between the first coil 300 and the second coil is determined, at least partly, by the ratio between the first surface delimited by the winding(s) 3000 and the second surface delimited by the winding(s) 3002, such that the value of this first coupling coefficient is equal a first target value. Further, a value of the coupling coefficient between the first coil 300 and the third coil is, for example, determined, at least partly, by the ratio between the first and second surfaces, such that the value of this second coupling coefficient is equal a second target value. As an example, when the second coil is of the dual coplanar loop type, the value of the coupling coefficient between the second coil and the third coil is determined, at least partly, by the ratio between the third and fourth surfaces of the second coil, such that the value of this third coupling coefficient is equal to a third target value.

Preferably, the winding(s) of the third coil are arranged in a third plan parallel to the first and second plans. Preferably, the third plan is different from the first and second plans.

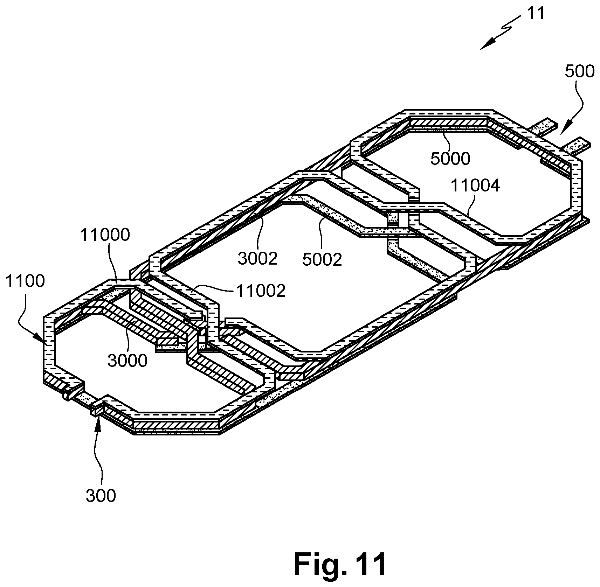

An example of a transformer with three coils is described in relation with figure 11.

Figure 11 illustrates, by a schematic tri-dimensional view, an example of an embodiment of a transformer having a value of the coupling coefficient between the primary and the secondary of the transformer equal to a target value.

In the example of figure 11, a third coil 1100 corresponding to second secondary of the transformer is added to the transformer 7 of figure 7, in order to get a transformer 11 having one primary coil and two secondary coils.

Thus, the transformer 11 is similar to the transformer 7 and comprises a lot of elements in common with the transformer 7. Thus, only the differences between the transformers 11 and 7 are here detailed. For example, unless indicated otherwise, everything that has been disclosed for the transformer 7 applies to the transformer 11.

The transformer 11 differs from the transformer 7 in that it comprises the third coil 1100. The winding(s) of the coil 1100 are arranged in a third plan which is parallel to the first plan of the windings of the first coil 300 and to the windings of the second coil 500.

Preferably, the third plan is different from the first and second plans, and the coil 1100 is disposed above the coils 300 and 500. In such a case, the area of the coil 300, the area of the coil 500 and the area of the coil 1100, when projected on a same plan parallel to the first, second and third plan are the same.

For example, the coil 1100 comprises at least one winding 11000 configured to generate a magnetic field in a fifth direction perpendicular to the third plan, at least one winding 11002 configured to generate a magnetic field in a sixth direction parallel and opposite to the fifth direction, and at least one winding 11004 configured to generate a magnetic field in seventh direction parallel and opposite to the sixth direction. The coil 11000 is then, for example, of the triple coplanar loop type.

In the example of the figure 11, the coil 1100 comprises only one winding 11000, only one winding 11002 and only one winding 11004. In other example, the coil 1100 may comprise a plurality of windings 11000 concentric with each other, a plurality of windings 11002 concentric with each other, and a plurality of windings 11004 concentric with each other.

According to one embodiment, a transformer of the type described in relation with the figures 3 to 11 is provided in a balancing unit configured to be connected between a source impedance and a load impedance.

Various embodiments and variants have been described. Those skilled in the art will understand that certain features of these embodiments can be combined and other variants will readily occur to those skilled in the art. In particular, as it has already been indicated above, those skilled in the art would be able to adapt the above described embodiments and examples of a transformer having two or three coils coupled with each other to the cases of coils having a number N of coils greater than 3. For example, a transformer having an even number N of coils greater than 3 could be seen as an assembly, for example, a stack, of a plurality of transformers with only two coils. For example, a transformer having an even number N of coils greater than 3 could be seen as an assembly, for example, a stack, of a plurality of transformers of the type described in relation with figures 2 to 10. For example, a transformer having an odd number N of coils greater than 3 could be seen as an assembly, for example, a stack, of one or a plurality of transformers with only two coils and of exactly one transformer with three coils. For example, a transformer having an odd number N of coils greater than 3 could be seen as an assembly, for example, a stack, of one or a plurality of transformers of the type described in relation with figures 2 to 10 and of exactly one transformer of the type described in relation with figure 11.

Finally, the practical implementation of the embodiments and variants described herein is within the capabilities of those skilled in the art based on the functional description provided hereinabove. In particular, those skilled in the will be capable of modifying the ratio of the first and second surfaces, and, for example, the ratio of the third and fourth surfaces, in order to get a value of the coupling coefficient equal to a target value. For example, in order to find the value of the ratio between the first and second surface, and, for example, of the ratio between the third and fifth surface corresponding to a given target value, those skilled in the art could simulate different ratio values using a tool for electromagnetic simulation, for example a simulation tool based on a finite element simulation or for example the simulation tool designed by the commercial name Keysight RFPro. Those skilled in the art will also be capable of using these simulation tool to try different length of metallic portion for connecting together the windings of a coil of the dual coplanar loop type in order to get the length that corresponds to a given capacitance value for the parasitic capacitance between the winding of this coil, for example to minimize this capacitance value.

## Claims

1. A transformer (4; 6; 7; 8; 9; 10; 11) comprising a first coil (300) and a second coil (302 ; 500; 1000) inductively coupled the one with the other, wherein :
the first coil comprises:
- at least one first winding (3000) arranged in a first plan and configured to generate a first magnetic field in a first direction perpendicular to the first plan; and
- at least one second winding (3002) arranged in the first plan and configured to generate a second magnetic field in a second direction perpendicular to the first plan and opposite to the first direction;
the first coil is 8-shaped and asymmetrical;
when the first and second coils are arranged in different plans, the first and second coils have a same area, and a footprint of the first coil projected on a projection plan parallel to said different plans is identical to a footprint of the second coil projected on the projection plan; and
when the first and second coils are both arranged in the first plan, one of the first and second coils is arranged in a surface laterally delimited by the other of the first and second coils, the first and second coils having sensibly a same footprint.

2. The transformer (8; 9; 10) according to claim 1, wherein the at least one first winding (3000) comprises a plurality of concentric first windings (3000) and the at least one second winding (3002) comprises a plurality of concentric second windings (3002), a number of second windings (3002) being, for example, equal to a number of first windings (3000).

3. The transformer (4; 6; 7; 11) according to claim 1, wherein the at least one first winding (3000) comprises only one first winding and the at least one second winding (3002) comprise only one second winding.

4. The transformer (4; 6; 7; 8; 9; 10; 11) according to any of claims 1 to 3, wherein the second coil (302; 500; 1000) comprises at least one third winding (3020; 5000; 10000) arranged in a second plan and configured to generate a third magnetic field in a third direction parallel to the first and second direction, the second plan being parallel to the first plan.

5. The transformer (4; 10) according to claim 4, wherein the second coil (302; 1000) is configured to generate only the third magnetic field.

6. The transformer (10) according to claim 5, wherein:
- the second plan is coplanar with the first plan;
- a third surface laterally delimited by the at least one third winding (10000) comprises, in the second plan, a first part included in a first surface laterally delimited by the at least one first winding (3000) and a second part included in a second surface laterally delimited by the at least one second winding (3002).

7. The transformer (4; 6; 7; 8; 9; 11) according to claim 5, wherein:
- the second plan is different from the first plan;
- a third surface laterally delimited by the at least one third winding (3020; 5000) comprises, in the second plan, a first part facing, in a direction parallel to the first and second directions, a first surface laterally delimited by the at least one first winding (3000) in the first plan, and a second part facing, in the direction parallel to the first and second directions, a second surface laterally delimited by the at least one second winding (3002) in the first plan.

8. The transformer (6; 7; 8; 9; 11) according to claim 4, wherein the second coil (500) further comprises at least one fourth winding (5002) arranged in the second plan and configured to generate a fourth magnetic field in a fourth direction parallel to the first and second directions and opposite to the third direction, the second plan being different from the first plan.

9. The transformer (8; 9) according to claim 8, wherein the at least one third winding (5000) comprises a plurality of third windings (5000) and the at least one fourth winding (5002) comprises a plurality of fourth windings (5002), a number of third windings (5000) being equal to a number of fourth windings (5002).

10. The transformer (9) according to any of claims 1 to 9, wherein the first and second windings (3000; 3002) are arranged in a first metal layer and the first and second windings are connected to each other by at least one metallic portion (3004) arranged in at least one metal layer different from the first metal layer, the length of the at least one metallic portion (3004) being determined by a target value of a parasitic capacitance between the first and second windings (3000; 3002).

11. The transformer (11) according to any of claims 1 to 10, wherein the transformer further comprises a third coil (1100) inductively coupled with each of the first and second coils (300; 500).

12. An integrated radio-frequency circuit comprising a balancing unit connected between a source impedance and a load impedance in a circuit, wherein the balancing unit comprises a transformer (4; 6; 7; 8; 9; 10; 11) according to any of claims 1 to 11.
